# EUROPEAN PATENT SPECIFICATION

(11) **EP 0 459 906 B1**
(45) Date of publication and mention of the grant of the patent: **24.09.1997**
(21) Application number: 91401408.9
(22) Date of filing: 30.05.1991
(51) Int. Cl.: H01L 39/22, H01L 39/24

(54) **Process for preparing superconducting junction of oxide superconductor**
Verfahren zur Herstellung eines supraleitenden Überganges aus oxydischem Supraleiter
Procédé pour la préparation d'une jonction supraconductrice d'oxyde supraconducteur

(30) Priority: 30.05.1990 JP 140516/90; 04.06.1990 JP 145936/90
(43) Date of publication of application: 04.12.1991
(73) Proprietor: SUMITOMO ELECTRIC INDUSTRIES, LTD., Osaka-shi, Osaka 541 (JP)
(72) Inventor: Tanaka, Saburo, c/o Itami Works, Itami-shi, Hyogo (JP); Nakanishi, Hidenori, c/o Itami Works, Itami-shi, Hyogo (JP); Itozaki, Hideo, c/o Itami Works, Itami-shi, Hyogo (JP); Matsuura, Takashi, c/o Itami Works, Itami-shi, Hyogo (JP)
(74) Representative: Bernasconi, Jean

(56) References cited:
- EP-A- 0 371 481
- EP-A- 0 445 350
- APPLIED PHYSICS LETTERS, vol. 56, no. 2, 8 January 1990, New York US, pp. 189-191; J.J. KINGSTON et al.: 'Multilayer YBa2Cu3Ox-SrTiO3-YBa2Cu3Ox films for insulating crossovers'
- APPLIED PHYSICS LETTERS, vol. 58, no. 18, 18 February 1991, New York US, pp. 765-767; M.E. TIDJANI et al.: 'Heteroepitaxial YBa2Cu3O7-x-SrTiO3-YBa2Cu3O7-x trilayers examined by transmission electron microscopy'
- IBM TECHNICAL DISCLOSURE BULLETIN, vol. 31, no. 9, February 1989, New York US, page 217; 'High Tc superconducting oxide sandwich structures and tunnel junctions'

## Description

### Background of the Invention

### Field of the invention

The present invention relates to a process for preparing surperconducting junctions of oxide superconductor such as Josephson junction, more particularly to a process for preparing a superconducting junction by depositing successively a first oxide superconductor thin film layer, a non-superconducting intermediate thin film layer and a second oxide superconductor thin film layer on a substrate in this order.

### Description of the related art

In order to realize electronics devices such as Josephson elements or superconducting transistors in which superconductor is combined with semiconductor, it is indispensable to deposit successively at least one thin film layer of superconductor and at least one thin film layer of non-superconductor on a substrate. Hereinafter, we will describe the present invention with reference to Josephson junction used for fabricating Josephson elements but it is apparent that the process according to the present invention is applicable to other types of superconducting devices.

Variations of Josephson Junctions have been reported. Among them, the most simplest type is the so-called tunnel Josephson Junction in which a non-superconducting thin film layer is sandwiched between a pair of superconductors. A tunnel type Josephson element is fabricated by processing microscopically a layered structure of 1st superconductor thin film layer/non-superconductor thin film layer/2nd superconductor thin film layer. In this Josephson Junction, the thickness of the intermediate thin film layer of non-superconducting is determined by the coherent length of superconductors.

Although several ideas for fabricating the tunnel type superconducting junctions from metallic superconductors have been reported, there is little report describing how to fabricate the same from oxide superconductors because there remain the following problems to be solved in order to prepare the tunnel type superconducting junctions having oxide superconductor thin film layers.

Firstly, in the case of tunnel type superconducting junctions having oxide superconductor thin film layers, the thickness of the non-superconducting intermediate thin film layer must be reduced to several nanometres (nm) because of the very short coherent length of oxide superconductor.

Secondly, it is difficult to deposit and/or laminate oxide thin films having good crystallinity successively. In particular, in the prior art, it is difficult to prepare an upper superconductor thin film layer having good crystallinity on a non-superconducting intermediate thin film layer due to very poor crystallinity of the latter layer. In order to improve performance of superconducting thin film devices, it is preferable that all thin film layers are made of single crystals. In fact, if any one of the layers is of a polycrystal or amorphous film, the tunnel type Josephson Junction does not work stably. In other words, there is a strong demand to prepare the second or upper superconductor thin film layer of single crystal having good crystallinity on a non-superconducting intermediate layer. Deposition of oxide superconductor thin film layer of single crystal having good crystallinity is requested also in the field of superconducting transistor having an interface between oxide superconductor and semiconductor.

In fact, tunnel type superconducting junctions prepared from oxide superconductor by the conventional technique did not show the desired electrical properties due to poor interface condition between the oxide superconductor thin film layer and the non-superconductor thin film layer.

In IBM Technical Disclosure Bulletin, vol. 31, No. 9 (1989) page 217, it is disclosed a tunnel type junction wherein a thin insulating film is sandwiched between two high Tc superconductors, with the feature that a layer of MgO of 15 nm (or more) has been sputtered on the as-deposited film after which the second superconducting layer (YBaCuO) is deposited as the top. The layered three layers are annealed simultaneously at the final stage.

EP-A-0 371 481 which concerns prior art under Article 54(3) EPC, provides a method for forming a continuous insulating MgO ultrathin film on a film of single crystal YBa₂Cu₃O₇₋ₓ having the (001) plane in a direction parallel with the film surface, said continuous insulating MgO ultrathin film having a thickness of not larger than 10 Å and the (001) plane in a direction parallel with the film surface. The intermediate layer is prepared by a chemical method.

Therefore, an object of the present invention is to solve the problems above described and to provide a process for improving crystallinity of the non-superconducting intermediate thin film layer and hence the second or upper superconducting thin film layer in order to permit high-temperature superconductors to be utilized in actual uses.

### Summary of the Invention

The present invention provides a process for fabricating a superconducting junction by depositing successively a first oxide superconductor thin film layer, a non-superconducting intermediate thin film layer and a second oxide superconductor thin film layer on a substrate in this order, wherein the non-superconducting intermediate thin film layer is composed of MgO, said substrate is heated at a temperature between 200 and 400°C while the non-superconducting intermediate thin film layer is deposited, the thickness of said non-superconducting intermediate thin film layer is larger than 1 nm and at most equal to 10 nm and all of said first and second oxide superconductor thin film layers and said non-superconducting intermediate thin film layer are prepared by a physical vapour deposition method.

Before the non-superconducting intermediate layer is deposited, the substrate on which the first oxide superconductor thin film layer has been deposited previously is preferably heated at a temperature between 600 and 650°C.

### Brief Description of the Drawing

Fig. 1 is a diagrammatical cross-sectional view of a product obtained by the process according to the present invention.

Fig. 2A and 2B are photos taken by a scanning electron spectroscopy (SEM) on cross-sections of products prepared in Example 1 according to the present invention.

Fig. 3 illustrates substrate temperature dependency of surface roughness and of crystal orientation in an intermediate thin film layer of MgO deposited on a first oxide superconducting thin film layer of Y₁Ba₂Cu₃O₇₋ₓ prepared in Example 3 according to the present invention.

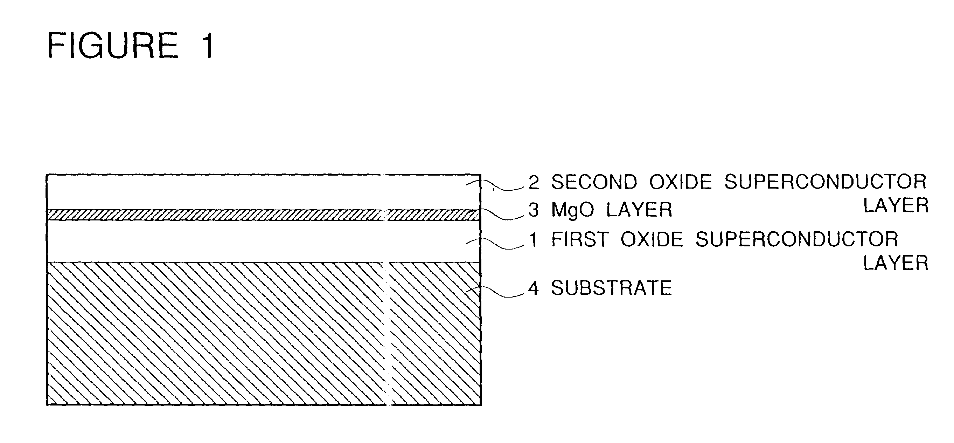

As is illustrated in Fig. 1, the superconducting junction prepared by the process according to the present invention has a layered structure consisting of a first oxide superconductor thin film layer (1), a non-superconducting intermediate thin film layer (3) and a second oxide superconductor thin film layer (2) deposited on a substrate (4) in this order.

The present invention resides in that the substrate is heated to a temperature between 200 and 400°C while the non-superconducting intermediate thin film layer of MgO is deposited. If the substrate is not heated higher than 200°C, the resulting thin film layer of MgO possesses poor crystallinity or becomes amorphous. To the contrary, if the substrate is heated above 400°C, the resulting thin film layer of MgO becomes polycrystal. In both cases, no desired superconducting junction can be obtained.

Thickness of the MgO thin film layer is also important in the process according to the present invention and lies between 1 and 10 nm. If the thickness of the MgO thin film layer is not greater than 1 nm, it is difficult to form a uniform thin film of MgO and the crystallinity of the thin film becomes poor. To the contrary, if the thickness of MgO thin film layer exceeds 10 nm, it is also difficult to deposit a well-ordered second superconductor thin film layer thereon because the crystallinity of MgO thin film layer is disturbed and a desired coherent length cannot be obtained.

All of the first and second oxide superconductor thin film layers and the non-superconducting intermediate thin film layer are prepared by a physical vapour deposition method including sputtering method, vacuum evaporation method and molecular beam epitaxy method.

In a preferred embodiment of the present invention, the first oxide superconductor thin film layer is prepared by sputtering, vacuum evaporation and molecular beam epitaxy and both of the non-superconducting intermediate thin film layer and the second oxide superconductor thin film layer are prepared by vacuum evaporation method which gives no bad influence to the under-layer.

The orientation directions of the first and second superconducting thin film layers can be made identical to each other. In fact, when the first superconducting thin film layer is a c-axis oriented film, the second superconducting thin film layer deposited thereon becomes also a c-axis oriented film, and, when the first superconducting thin film layer is an a-axis oriented film, the second superconducting thin film layer deposited thereon becomes also an a-axis oriented film. Selection of orientation can be made according to applications. Orientation of superconducting thin film layers can be changed by controlling the substrate temperature during deposition. For example, in the case of a thin film layer of Y-Ba-Cu-O system deposited on a single crystal of MgO (100) by sputtering method, a c-axis oriented superconducting thin film is obtained at a substrate temperature of 630°C, while an a-axis oriented superconducting thin film is obtained at a substrate temperature of 600°C.

The first and second oxide superconductor thin film layers are preferably made of a compound oxide selected from the group comprising Y-Ba-Cu-O system such as Y₁Ba₂Cu₃O₇₋ₓ, Bi-Sr-Ca-Cu-O system such as Bi₂Sr₂Ca₂Cu₃Oₓ and Tl-Ba-Ca-Cu-O system such as Tl₂Ba₂Ca₂Cu₃Oₓ. Y₁Ba₂Cu₃O₇₋ₓ is preferable because thin films of high quality are obtainable stably and Tl₂Ba₂Ca₂Cu₃Oₓ is also preferable due to its high critical temperature (Tc).

The substrate is not limited but is preferably a single crystal substrate of oxide such as MgO, SrTiO₃, LaAlO₃, LaGaO₃ and yttrium stabilized zirconia (YSZ). The first oxide superconductor thin film layer is deposited preferably on a (100) plane of a single crystal substrate of MgO.

The substrate on which the first oxide superconductor thin film layer has been deposited previously is heated to a temperature between 600 and 650°C, before the non-superconducting intermediate thin film layer is deposited. By this heat-treatment, the surface of the thin film layer of MgO is cleaned and the quality of the second superconducting thin film layer is improved.

This heat-treatment is effected preferably in oxygen-containing atmosphere.

Inventors of this application found that this technique is not limited to the thin film layer of MgO but is applicable to the other non-superconducting intermediate layers such as SrTiO₃, LaAlO₃ or LaGaO₃.

In particular, this heat-treatment technique is advantageous when the intermediate layer is prepared by a different method from that used for depositing the first superconducting thin film layer. For example, when first superconducting thin film layer is prepared by sputtering method while the intermediate layer and/or the second superconducting thin film layer are prepared by vacuum evaporation method, a substrate on which first superconducting thin film layer is deposited is transferred from a chamber of sputtering unit to another chamber of vacuum evaporation unit. The surface of the first superconducting thin film layer is exposed to atmosphere and may be deteriorated during the transfer. Such spoiled surface can be cleaned by the heat-treatment technique according to the present invention.

When the temperature of this heat-treatment is not higher than 600°C, effective cleaning cannot be expected. To the contrary, if the temperature of this heat-treatment exceeds 650°C, the first superconducting thin film layer is deteriorated due to migration of substrate material into the superconducting thin film layer and recrystallization of the latter. This heat-treatment is preferably carried out for more than 5 minutes.

The other operational conditions except the temperature during the heat-treatment can be identical with those used in the above-mentioned case.

In conclusion, the process according to the present invention has following avantages:
(1) A thin film of high quality can be deposited on an oxide superconducting thin film layer.
(2) A tunnel type superconducting junction which is an indispensable element for realizing electronics devices can be obtained.
(3) The orientation of crystals can be controlled freely, so that the critical current density can be flown in parallel with (c-axis oriented film) or perpendicular to (a-axis oriented film) the surface of the substrate.

### Description of the Preferred Embodiments

Now, the present invention will be described with reference to Examples, but the scope of the present invention should not be limited thereto.

### Example 1

At first, a superconducting thin film layer having a composition of Y₁Ba₂Cu₃O₇₋ₓ was deposited on a (100) plane of a MgO single crystal by RF-magnetron sputtering.

In this example, both of c-axis oriented and a-axis oriented thin films of superconductors of Y₁Ba₂Cu₃O₇₋ₓ were prepared by changing the substrate temperature.

The essential operational conditions used for preparing the first oxide superconducting thin film layer are as follows:
- Substrate temperature:: 630°C for c-axis oriented film 600°C for a-axis oriented film
- Sputtering gas:: Ar: 8 sccm
O₂: 4 sccm
- Gas pressure:: 6.65 Pa (5 x 10⁻² Torr)
- Thickness of 1 st layer:: 300 nm

The resulting substrate having the first oxide superconducting thin film layer was transferred from a sputtering chamber to a vacuum evaporation chamber and then a non-superconducting intermediate thin film layer of MgO was deposited on the first oxide superconducting thin film layer by vacuum evaporation method. The essential operational conditions used for preparing the MgO layer are as follows:
- Substrate temperature:: 400°C
- Gas pressure:: 0.0532 Pa (4 x 10⁻⁴ Torr)
- Thickness of MgO:: 5 nm

Then, in the same chamber, a second oxide superconducting thin film layer of Y₁Ba₂Cu₃O₇₋ₓ was deposited on the resulting MgO thin film layer by vacuum deposition method. The essential operational conditions used for preparing the 2nd layer are as follows:
- Substrate temperature:: 630°C
- Gas pressure:: 0.0532 Pa (4 x 10⁻⁴ Torr)
- Thickness of 2nd layer:: 200 nm

It was confirmed, by a scanning electron microscopy (SEM) that, when the first oxide superconducting thin film layer was a c-axis oriented film of Y₁Ba₂Cu₃O₇₋ₓ, the second oxide superconducting thin film layer deposited thereon through MgO thin film layer became also a c-axis oriented film of Y₁Ba₂Cu₃O₇₋ₓ, and, when the first oxide superconducting thin film layer was an a-axis oriented film, the second oxide superconducting thin film layer deposited thereon through MgO thin film layer became also an a-axis oriented film.

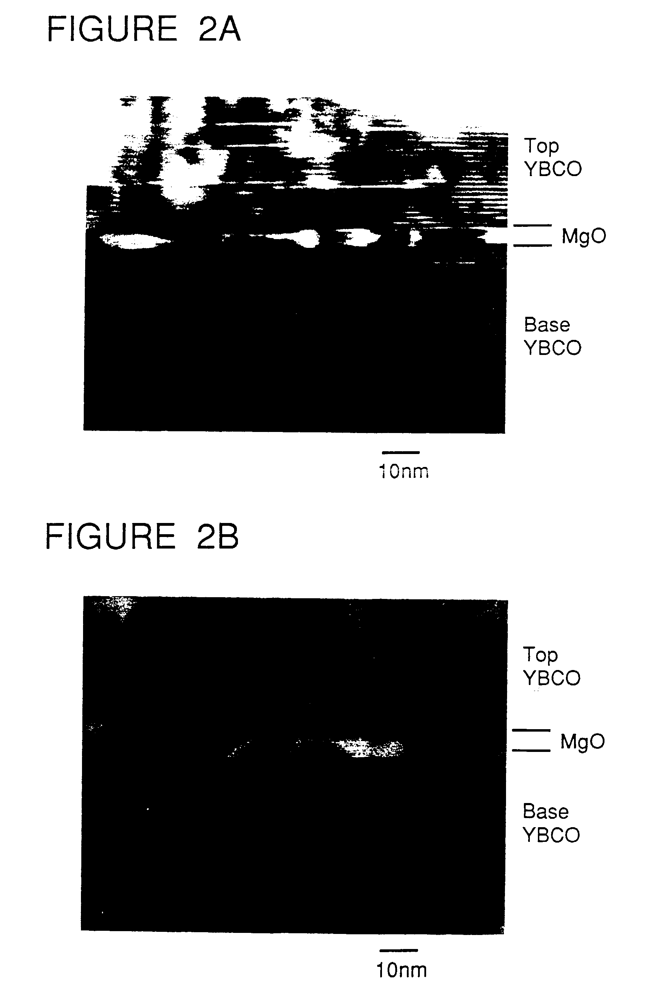

Fig. 2A is a photo taken by a scanning electron spectroscopy (SEM) on a cross-section of the resulting layered structure of Y₁Ba₂Cu₃O₇₋ₓ/MgO/Y₁Ba₂Cu₃O₇₋ₓ in which both of the 1st and 2nd oxide superconducting thin film layers were c-axis oriented films.

Fig. 2B is a photo taken by a scanning electron spectroscopy (SEM) on a cross-section of the resulting layered structure of Y₁Ba₂Cu₃O₇₋ₓ/MgO/Y₁Ba₂Cu₃O₇₋ₓ in which both of the 1st and 2nd oxide superconducting thin film layers were a-axis oriented films.

Fig. 2A and 2B reveal that crystals of Y₁Ba₂Cu₃O₇₋ₓ in the first and second oxide superconducting thin film layers were oriented along an identical direction in the superconducting junctions prepared by the process according to the present invention and that an interface between MgO intermediate thin film layer and first/second oxide superconducting thin film layer is very sharp and has no serious disorder.

### Example 2

The same procedure as in Example 1 was repeated but first/second oxide superconducting thin film layers of Y₁Ba₂Cu₃O₇₋ₓ were replaced by Bi₂Sr₂Ca₂Cu₃Oₓ.

The essential operational conditions used for preparing the first oxide superconducting thin film layer are as follows:
- Substrate temperature:: 660°C for c-axis oriented film 630°C for a-axis oriented film
- Sputtering gas:: Ar: 8 sccm
O₂: 4 sccm
- Gas pressure:: 6.65 Pa (5 x 10⁻² Torr)
- Thickness of 1 st layer:: 300 nm

The essential operational conditions used for preparing the MgO layer are as follows:
- Substrate temperature:: 400°C
- Gas pressure:: 0.0532 Pa (4 x 10⁻⁴ Torr)
- Thickness of MgO:: 5 nm

Then, in the same chamber, a second oxide superconducting thin film layer of Bi₂Sr₂Ca₂Cu₃Oₓ was deposited on the resulting MgO thin film layer by vacuum deposition method. The essential operational conditions used for preparing the 2nd layer are as follows:
- Substrate temperature:: 660°C
- Gas pressure:: 0.0532 Pa (4 x 10⁻⁴ Torr)
- Thickness of 2nd layer:: 200 nm

In this Example also, it was confirmed, by a scanning electron microscopy (SEM) that, when the first oxide superconducting thin film layer was a c-axis oriented film of Bi₂Sr₂Ca₂Cu₃Oₓ, the second oxide superconducting thin film layer deposited thereon through MgO thin film layer became also a c-axis oriented film of Bi₂Sr₂Ca₂Cu₃Oₓ, and, when the first oxide superconducting thin film layer was an a-axis oriented film, the second oxide superconducting thin film layer deposited thereon through MgO thin film layer became also an a-axis oriented film and that crystals of Bi₂Sr₂Ca₂Cu₃Oₓ in the first and second oxide superconducting thin film layers were oriented along an identical direction in the superconducting junctions and also that an interface between MgO intermediate thin film layer and first/second oxide superconducting thin film layer was very sharp and had no serious disorder.

### Example 3

The same procedure as in Example 1 was repeated but the substrate temperature for depositing the intermediate thin film layer of MgO was modified.

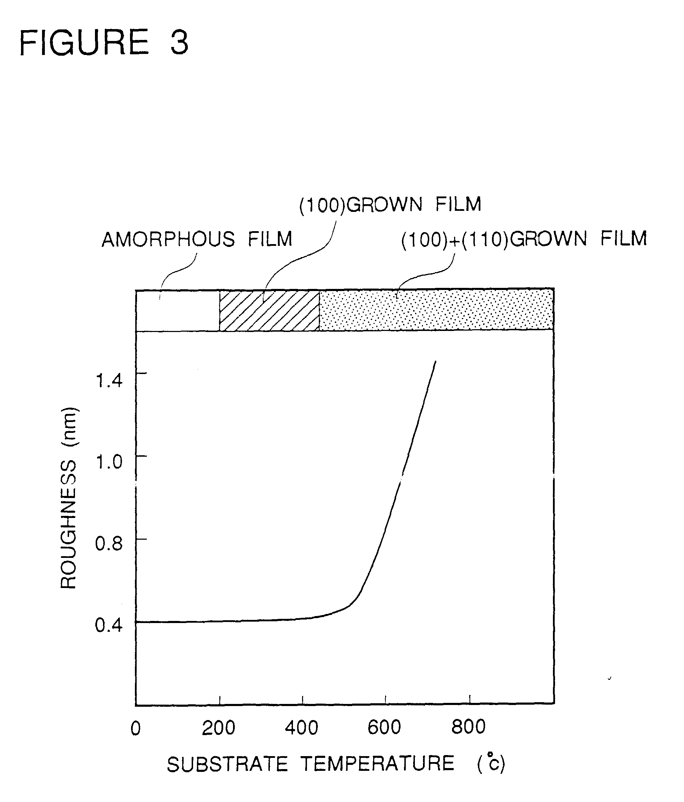

The results are summarized in Fig. 3 which illustrates substrate temperature dependency of surface roughness and of crystal orientation in an intermediate thin film layer of MgO deposited on a first oxide superconducting thin film layer Y₁Ba₂Cu₃O₇₋ₓ.

Fig. 3 reveals that intermediate non-superconducting thin film layers of MgO deposited on the first oxide superconducting thin film layer of Y₁Ba₂Cu₃O₇₋ₓ show uneven or rough surface at substrate temperatures higher than 400°C and become amorphous at substrate temperatures lower than 200°C.

Fig. 3 reveals also that the intermediate non-superconducting thin film layers of MgO contains (110) plane on its surface on which the second superconducting thin film layer will be deposited, in addition to (100) plane. Such mixed planes result in deterioration of crystallinity.

From this result, it was confirmed that it is indispensable to limit the substrate temperature between 200°C and 400°C in order to realize a smooth (100) plane possessing improved crystallinity which is an indispensable condition to produce the second oxide superconducting thin film layer having the same deposition plane as the first oxide superconducting thin film layer.

### Example 4

In this Example, a first oxide superconducting thin film layer was heat-treated previously before an intermediate non-superconducting thin film layer was deposited.

At first, a superconducting thin film layer having a composition of Y₁Ba₂Cu₃O₇₋ₓ was deposited on a (100) plane of a MgO single crystal by RF-magnetron sputtering.

The essential operational conditions used for preparing the first oxide superconducting thin film layer are as follows:
- Substrate temperature:: 630°C for c-axis oriented film
- Sputtering gas:: Ar: 8 sccm
O₂: 4 sccm
- Gas pressure:: 6.65 Pa (5 x 10⁻² Torr)
- Thickness of 1 st layer:: 300 nm

The resulting substrate having the first oxide superconducting thin film layer was transferred from a sputtering chamber to a vacuum evaporation chamber.

In the vacuum evaporation chamber, the heat-treatment was effected with supplying oxygen gas through a nozzle onto a surface of the substrate for 30 minutes, under following conditions:
- Substrate temperature:: 600°C for c-axis oriented film
- Surrounding gas:: O₂
- Gas pressure:: 0.0532 Pa (4 x 10⁻⁴ Torr) (This value is a pressure in the vacuum evaporation chamber but is not a pressure around the substrate where gas pressure may be one to two orders (10⁻³ to 10⁻²) higher than this value)

Then, the substrate was left to be cooled down to 400°C.

After then, a non-superconducting intermediate thin film layer of MgO was deposited on the heat-treated first oxide superconducting thin film layer by vacuum evaporation method. The essential operational conditions used for preparing the MgO layer are as follows:
- Substrate temperature:: 400°C
- Gas pressure:: 0.0532 Pa (4 x 10⁻⁴ Torr)
- Thickness of MgO:: 5 nm

Then, in the same chamber, a second oxide superconducting thin film layer of Y₁Ba₂Cu₃O₇₋ₓ was deposited on the resulting MgO thin film layer by vacuum deposition method. The essential operational conditions used for preparing the 2nd layer are as follows:
- Substrate temperature:: 630°C
- Gas pressure:: 0.0532 Pa (4 x 10⁻⁴ Torr)
- Thickness of 2nd layer:: 200 nm

By a scanning electron microscopy (SEM), it was confirmed that an interface between MgO intermediate thin film layer and first/second oxide superconducting thin film layer was very sharp and that disorder of crystals at the interface was less than 1 nm in width.

In a comparative example which was not subjected to the heat-treatment, disorder of crystals in width at the interface of 5 to 10 nm was observed.

### Example 5

The same procedure as in example 4 was repeated but first/second oxide superconducting thin film layers of Y₁Ba₂Cu₃O₇₋ₓ were replaced by Bi₂Sr₂Ca₂Cu₃Oₓ.

The essential operational conditions used for preparing the first oxide superconducting thin film layer are as follows:
- Substrate temperature:: 660°C for c-axis oriented film
- Sputtering gas:: Ar: 8 sccm
O₂: 4 sccm
- Gas pressure:: 6.65 Pa (5 x 10⁻² Torr)
- Thickness of 1 st layer:: 300 nm

Heat-treatment was effected for 30 minutes under following conditions:
- Substrate temperature:: 600°C for c-axis oriented film
- Surrounding gas:: O₂
- Gas pressure:: 0.0532 Pa (4 x 10⁻⁴ Torr)

The essential operational conditions used for preparing the MgO layer are as follows:
- Substrate temperature:: 400°C
- Gas pressure:: 0.0532 Pa (4 x 10⁻⁴ Torr)
- Thickness of MgO:: 5 nm

Then, in the same chamber, a second oxide superconducting thin film layer of Bi₂Sr₂Ca₂Cu₃Oₓ was deposited on the resulting MgO thin film layer by vacuum deposition method. The essential operational conditions used for preparing the 2nd layer are as follows:
- Substrate temperature:: 650°C
- Gas pressure:: 0.0532 Pa (4 x 10⁻⁴ Torr)
- Thickness of 2nd layer:: 300 nm

By a scanning electron microscopy (SEM), it was confirmed that an interface between MgO intermediate thin film layer and first/second oxide superconducting thin film layer was very sharp and that no substantial disorder of crystals at the interface was observed.

In a comparative example which was not subjected to the heat-treatment, disorder of crystals in width at the interface of 5 to 10 nm was observed.

## Claims

1. A process for fabricating a superconducting junction by depositing successively a first oxide superconductor thin film layer (1), a non-superconducting intermediate MgO thin film layer (3) and a second oxide superconductor thin film layer (2) on a substrate (4) in this order, wherein said substrate (4) is heated to a temperature between 200 and 400°C while said non-superconducting intermediate thin film layer (3) is deposited and wherein the thickness of said non-superconducting intermediate thin film layer (3) is larger than 1 nm and at most equal to 10 nm, all of said first and second oxide superconductor thin film layers (1,2) and said non-superconducting intermediate thin film layer (3) being prepared by a physical vapour deposition method.

2. The process set forth in Claim 1 wherein both of said non-superconducting intermediate layer (3) and said second oxide superconductor thin film layer (2) are prepared by a vacuum deposition method.

3. The process set forth in any one of Claims 1 and 2, wherein said first thin film layer (1) is an a-axis oriented thin film or a c-axis oriented thin film.

4. The process set forth in any one of Claims 1 to 3, wherein the first and second oxide superconductor thin film layers (1,2) are made of a compound oxide selected from the group comprising Y-Ba-Cu-O system, Bi-Sr-Ca-Cu-O system and Tl-Ba-Ca-Cu-O system.

5. The process set forth in any one of Claims 1 to 3, wherein said substrate (4) is a single crystal substrate of oxide.

6. The process set forth in Claim 5 wherein said substrate (4) is a single crystal substrate of oxide selected from the group comprising MgO, SrTiO₃, LaAlO₃, LaGaO₃ and yttrium stabilized zirconia (YSZ).

7. The process set forth in Claim 6 wherein said first oxide superconductor thin film layer (1) is deposited on a (100) plane of a single crystal substrate of MgO.

8. The process set forth in any one of Claims 1 to 7 wherein, before said non-superconducting intermediate layer (3) is deposited, said substrate (4) on which said first oxide superconductor thin film layer (1) has been deposited previously is heated to a temperature between 600 and 650°C.

9. The process set forth in Claim 8 wherein said substrate (4) is heated in an oxygen containing atmosphere.

## Patentansprüche

1. Verfahren zur Herstellung eines supraleitenden Übergangs durch aufeinanderfolgendes Abscheiden einer ersten oxidischen supraleitenden Dünnschicht (1), einer nichtsupraleitenden Zwischen-Dünnschicht (3) aus MgO und einer zweiten oxidischen supraleitenden Dünnschicht (2) auf einem Substrat (4), in dieser Reihenfolge, wobei das Substrat (4) auf eine Temperatur zwischen 200 und 400°C aufgeheizt wird während die nicht-supraleitende Zwischen-Dünnschicht (3) abgeschieden wird und wobei die Dicke der nichtsupraleitenden Zwischen-Dünnschicht (3) grösser als 1 nm und höchstens gleich 10 nm ist, und wobei sowohl die erste als auch die zweite oxidischen supraleitenden Dünnschichten (1, 2) als auch die nicht-supraleitende Zwischen-Dünnschicht (3) durch ein physikalisches Dampfabscheideverfahren erzeugt werden.

2. verfahren nach Anspruch 1, bei dem sowohl die nicht-supraleitende Zwischen-Dünnschicht (3) als auch die zweite oxidische supraleitende Dünnschicht (2) durch ein Vakuumabscheideverfahren erzeugt werden.

3. Verfahren nach einem der Ansprüche 1 und 2, wobei die erste Dünnschicht (1) eine Dünnschicht mit a-Achsorientierung oder eine Dünnschicht mit c-Achsorientierung ist.

4. Verfahren nach einem der Ansprüche 1 bis 3, bei dem die erste und die zweite oxidische supraleitende Dünnschicht (1, 2) aus einem Verbundoxid bestehen, das ausgewählt ist aus der Gruppe bestehend aus einer Y-Ba-Cu-O-Verbindung, einer Bi-Sr-Ca-Cu-O-Verbindung und einer Tl-Ba-Cu-O-Verbindung.

5. Verfahren nach einem der Ansprüche 1 bis 3, bei dem das Substrat (4) ein Einkristallsubstrat aus einem Oxid ist.

6. Verfahren nach Anspruch 5, bei dem das Substrat (4) ein Einkristallsubstrat aus einem Oxid ist, das ausgewählt ist aus der Gruppe bestehend aus MgO, SrTiO₃, LaAlO₃, LaGaO₃ und yttriumstabilisiertem Zirkoniumdioxid (YSZ).

7. Verfahren nach Anspruch 6, bei dem die erste oxidische supraleitende Dünnschicht (1) auf einer (100)-Ebene eines Einkristallsubstrats aus MgO abgeschieden wird.

8. Verfahren nach einem der Ansprüche 1 bis 7, bei dem, bevor die nicht-supraleitende Zwischenschicht (3) abgeschieden wird, das Substrat (4) auf dem die erste oxidische supraleitende Dünnschicht (1) abgeschieden worden ist, auf eine Temperatur zwischen 600 und 650°C aufgeheizt wird

9. Verfahren nach Anspruch 8, bei dem das Substrat (4) in einer sauerstoffhaltigen Atmosphäre aufgeheizt wird.

## Revendications

1. Procédé pour la préparation d'une jonction supraconductrice par dépôt successivement d'une première couche (1) de film mince supraconductrice d'oxyde, d'une couche (3) de film mince intermédiaire de MgO non supraconductrice et d'une seconde couche (2) de film mince supraconductrice d'oxyde, sur un substrat (4), dans cet ordre, où ledit substrat (4) est chauffé à une température entre 200 et 400°C tandis que ladite couche (3) de film mince intermédiaire non supraconductrice est déposée et où l'épaisseur de ladite couche (3) de film mince intermédiaire non supraconductrice est supérieure à 1 nm et au plus égale à 10 nm, lesdites première et seconde couches (1, 2) de film mince supraconductrices d'oxyde et ladite couche (3) de film mince intermédiaire non supraconductrice étant toutes préparées par dépôt en phase gazeuse par procédé physique.

2. Procédé selon la revendication 1, où ladite couche (3) intermédiaire non supraconductrice et ladite seconde couche (2) de film mince supraconductrice d'oxyde sont toutes deux préparées selon un procédé de dépôt sous vide.

3. Procédé selon l'une quelconque des revendications 1 et 2, où ladite première couche (1) de film mince est un film mince orienté selon l'axe a ou un film mince orienté selon l'axe c.

4. Procédé selon l'une quelconque des revendications 1 à 3, où ladite première et ladite seconde couches (1, 2) de film mince supraconductrices d'oxyde sont faites d'un oxyde mixte choisi dans le groupe comprenant le système Y-Ba-Cu-O, le système Bi-Sr-Ca-Cu-O et le système Tl-Ba-Ca-Cu-O.

5. Procédé selon l'une quelconque des revendications 1 à 3, où ledit substrat (4) est un substrat monocristallin d'oxyde.

6. Procédé selon la revendication 5, où ledit substrat (4) est un substrat monocristallin d'oxyde choisi dans le groupe comprenant MgO, SrTiO₃, LaAlO₃, LaGaO₃ et la zircone stabilisée par l'yttrium (YSZ).

7. Procédé selon la revendication 6, où ladite première couche (1) de film mince supraconductrice d'oxyde est déposée sur un plan (100) d'un substrat monocristallin de MgO.

8. Procédé selon l'une quelconque des revendications 1 à 7, où, avant le dépôt de ladite couche (3) intermédiaire non supraconductrice, ledit substrat (4), sur lequel ladite première couche (1) de film mince supraconductrice d'oxyde a été précédemment déposée, est chauffé à une température entre 600 et 650°C.

9. Procédé selon la revendication 8, où ledit substrat (4) est chauffé dans une atmosphère contenant de l'oxygène.
